# DEMANDE DE BREVET EUROPEEN

(11) **EP 4 345 578 A1**
(43) Date de publication de la demande: **03.04.2024**
(21) Numéro de dépôt: 22306440.3
(22) Date de dépôt: 28.09.2022
(51) Int. Cl.: G06F 1/20, H05K 7/20

(54) **PLAQUE FROIDE ASSEMBLÉE POUR LAME DE CALCUL**

(71) Demandeur: BULL SAS, 78340 Les Clayes-Sous-Bois (FR)
(72) Inventeur: RAETH, Marc, 78910 TACOIGNIÈRES (FR); DEMANGE, Fabien, 78260 ACHÈRES (FR)
(74) Mandataire: Argyma

(57) **Abrégé**

Plaque froide (1) pour lame de calcul de supercalculateur, ladite plaque froide (1) délimitant au moins une ouverture (O1, O2) configurée pour recevoir au moins un dissipateur thermique destiné à refroidir au moins un composant électronique, ladite plaque froide (1) comprenant un circuit de refroidissement, comportant des canaux à l'intérieur desquels est destiné à circuler un fluide caloporteur dit « froid » pour alimenter ledit au moins un dissipateur thermique, et un circuit d'évacuation, comportant des canaux à l'intérieur desquels est destiné à circuler un fluide caloporteur dit « chaud » après réchauffement à travers l'au moins un dissipateur thermique, ladite plaque froide (1) consiste en un assemblage de plusieurs éléments distincts, dans lequel chaque paire d'éléments (10, 20, 30, 40, 50, 60) adjacents reliés fluidiquement au niveau d'une portion du circuit de refroidissement ou du circuit d'évacuation comporte à l'interface de ladite liaison un organe d'étanchéité (200).

## Description

### [Domaine technique]

La présente invention se rapporte au domaine des supercalculateurs et concerne plus particulièrement une plaque froide pour lame de calcul d'un supercalculateur.

### [Etat de la technique antérieure]

Un calculateur HPC (High Performance Computing), ou supercalculateur, comprend une pluralité de lames de calcul se présentant sous la forme de modules insérés dans une baie. Chaque lame de calcul comprend une carte mère comportant une pluralité de processeurs configurés chacun pour traiter des données.

Dans les calculateurs HPC à refroidissement liquide, la carte mère est montée sous une plaque dite « froide » à travers laquelle sont montés des dissipateurs thermiques permettant de refroidir les processeurs. La plaque froide comprend un circuit de refroidissement, permettant d'acheminer un fluide caloporteur jusqu'à l'entrée des dissipateurs thermiques, et un circuit d'évacuation, permettant d'acheminer le fluide caloporteur réchauffé sortant des dissipateurs thermiques en dehors de la plaque froide dans une unité externe de refroidissement du fluide, par exemple de type échangeur de chaleur eau-eau, dans le but de transférer la chaleur, par exemple vers un réseau domestique d'eau.

La solution de plaque froide principale en aluminium est à ce jour assez peu répandue et rares sont les systèmes qui capturent l'ensemble des calories dissipées dans la lame de calcul dans le réseau hydraulique. Un autre type de solution utilise des dissipateurs thermiques indépendants et n'est donc pas concerné par la problématique présentée ici.

Certaines solutions utilisent des pièces de cuivre interconnectées les unes aux autres via des tuyaux souples.

Enfin, d'autres solutions utilisent des techniques de refroidissement par immersion mono ou diphasique où les serveurs sont directement plongés dans un liquide diélectrique.

Des plaques froides monobloc sont utilisées dans l'automobile ou dans l'aéronautique avec des échangeurs en aluminium de grandes dimensions souvent brasés et lourdement outillés.

Historiquement, les premières plaques froides réalisées par la Demanderesse étaient faites d'un seul et même tenant monobloc. Les dimensions étant relativement faibles, la contrainte de fabricabilité due aux dimensions avait peu d'impact et la fiabilité en termes d'étanchéité était favorisée avec un bloc d'aluminium unique dans lequel passait le chemin d'eau.

Les plaques froides monobloc connues présentent cependant plusieurs inconvénients. Pour les grandes pièces, cette solution n'est pas compatible avec la taille des machines de friction malaxage utilisées pour leur fabrication. De plus, sur ces pièces avec des dimensions relativement importantes (diagonale autour de 800 mm), l'obtention d'une bonne planéité finale autour de 0,1 mm est très difficile à obtenir. L'échauffement des pièces lors du procédé de friction malaxage crée des déformations qu'il est très difficile de contrôler sur des pièces d'aussi grandes dimensions.

Dès que le système présente des ouvertures internes, la perte de matière engendrée par la solution monobloc rend cette solution peu compétitive économiquement (coût matière et temps d'usinage rallongé).

Le design est unique par définition et donc doit être entièrement modifié en cas de problème et très difficilement réutilisable dès que la géométrie de l'objet à refroidir change.

Il existe donc un besoin d'une solution simple et efficace permettant de remédier au moins en partie à ces inconvénients.

### [Exposé de l'invention]

A cette fin, l'invention a tout d'abord pour objet une plaque froide pour lame de calcul de supercalculateur, ladite plaque froide délimitant au moins une ouverture configurée pour recevoir au moins un dissipateur thermique destiné à refroidir au moins un composant électronique, ladite plaque froide comprenant un circuit de refroidissement, comportant des canaux à l'intérieur desquels est destiné à circuler un fluide caloporteur dit « froid » pour alimenter ledit au moins un dissipateur thermique, et un circuit d'évacuation, comportant des canaux à l'intérieur desquels est destiné à circuler un fluide caloporteur dit « chaud » après réchauffement à travers l'au moins un dissipateur thermique, ladite plaque froide étant remarquable en ce qu'elle consiste en un (ou est constituée d'un) assemblage de plusieurs éléments distincts dans lequel chaque paire d'éléments adjacents reliés fluidiquement au niveau d'une portion du circuit de refroidissement ou du circuit d'évacuation comporte à l'interface de ladite liaison un organe d'étanchéité.

La plaque froide selon l'invention permet d'éviter de devoir usiner de la matière pour former les ouvertures dans lesquelles seront disposés les dissipateurs thermiques, au contraire d'une plaque monobloc qui doit subir un usinage pour former les ouvertures. La matière ainsi économisée permet de réduire le coût de la plaque. Ensuite, l'utilisation de plusieurs éléments permet d'adapter la plaque froide à différentes formes et à différents types de dissipateurs thermiques et de lames de calcul. De plus, des éléments de faibles dimensions sont plus facilement fabricables et entraînent moins de déformations de la plaque froide. En outre, certains éléments peuvent être réutilisés d'un type de plaque froide à un autre ou bien au sein d'une même plaque froide afin de faciliter la fabrication des pièces et de réduire les coûts de la plaque froide. Similairement, un élément peut facilement être remplacé sans devoir changer toute la plaque froide. Avec plusieurs éléments, il est possible de choisir différents matériaux et processus de fabrication, notamment pour les éléments qui ne sont pas en contact avec le fluide réfrigérant. La manière dont les pièces sont découpées et assemblées entre elles est peu triviale car elle nécessite des calculs de rigidité mécanique et de pourcentage de perte de matière lors des phases d'usinage.

Avantageusement, la forme générale de la plaque froide est définie pour l'extérieur en fonction des interfaces de l'armoire informatique et pour l'intérieur en fonction de la localisation des éléments dissipatifs à refroidir.

Le découpage des pièces est réalisé afin de permettre le meilleur compromis entre les optimisations de matière perdue lors de la fabrication, la rigidité et les tolérances de montage mécanique de l'ensemble fini ainsi que de la limitation du nombre d'interfaces hydrauliques avec joints.

Certains éléments servent à la circulation du liquide caloporteur et doivent suivre les règles de fabrication en aluminium par friction malaxage, d'autres sont de pures pièces usinées dont les matériaux peuvent être adaptés si nécessaire.

De préférence, l'organe d'étanchéité est de type joint torique.

Avantageusement, les éléments de la plaque froide sont fixés entre eux deux à deux par des organes de fixation, de préférence de type vis de fixation.

Selon un aspect de l'invention, au moins une paire d'éléments de la plaque froide comporte des organes de positionnement.

De préférence, chaque paire d'éléments adjacents de la plaque froide comporte de organes de positionnement au niveau de leur liaison.

De manière avantageuse, les organes de positionnement comprennent au moins un pion d'indexage s'insérant dans une forme complémentaire, par exemple une cavité, afin de positionner parfaitement les deux éléments lors de leur assemblage, notamment afin de s'assurer que les organes d'étanchéité sont positionnés correctement pour une parfaite étanchéité de la plaque froide.

De préférence, les pions d'indexage et les formes complémentaires sont prévus avec des tolérances serrées, ce qui permet notamment de garantir de bonnes positions relatives avant le serrage des vis de fixation.

Selon un aspect de l'invention, les éléments sont réalisés en métal, de préférence en aluminium.

L'invention concerne également un procédé d'assemblage d'une plaque froide telle que présentée précédemment, ledit procédé comprenant une étape de positionnement des éléments entre eux et une étape de fixation des éléments entre eux de sorte à former le circuit de refroidissement et le circuit d'évacuation, le positionnement des éléments entre eux comprenant le placement d'un organe d'étanchéité à chaque interface de liaison fluidique d'une portion du circuit de refroidissement et/ou du circuit d'évacuation d'éléments adjacents.

Avantageusement, la fixation des éléments peut être réalisée deux à deux.

De préférence, la fixation se fait par emboitement ou par vissage.

Avantageusement encore, le positionnement des éléments entre eux comprend le guidage des éléments par des organes de positionnement.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig 1] La figure 1 illustre schématiquement une forme de réalisation de la plaque froide selon l'invention, en vue éclatée.
[Fig 2] La figure 2 illustre schématiquement la plaque froide de la figure 1 assemblée.
[Fig 3] La figure 3 illustre schématiquement une vue de la jonction, notamment de la liaison fluidique, entre le bord proximal et la pièce centrale de la plaque froide de la figure 1.
[Fig 4] La figure 4 illustre schématiquement en vue éclatée les organes de positionnement situés à la jonction entre le bord proximal et l'organe de jonction de la plaque froide de la figure 1.
[Fig 5] La figure 5 illustre schématiquement un mode de réalisation du procédé selon l'invention.

### [Description des modes de réalisation]

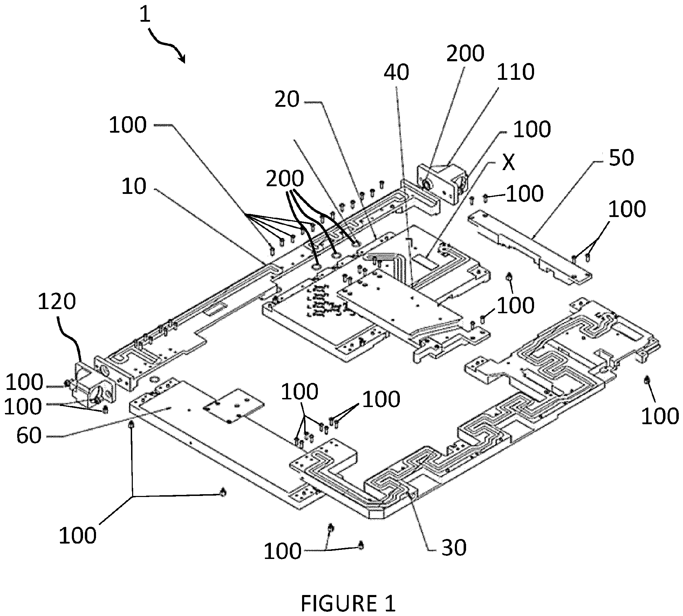

La figure 1 illustre un exemple d'éléments d'une plaque froide 1 avant assemblage.

La plaque froide 1 selon l'invention est destinée à être montée dans une lame de calcul d'un supercalculateur (non représentés). Une telle lame de calcul comprend des composants électroniques, notamment de type processeurs, permettant de traiter des données informatiquement.

La plaque froide 1 a notamment pour but de constituer un circuit de circulation d'un fluide réfrigérant dans lequel sont placés un ou plusieurs dissipateurs thermiques permettant de refroidir les processeurs et autres composants électroniques de la lame de calcul. Le circuit de circulation du fluide réfrigérant comporte une partie amont, appelée « circuit de refroidissement », qui a pour rôle d'acheminer le fluide réfrigérant dit « froid » jusqu'à l'entrée des dissipateurs thermiques, et une partie avale, appelée « circuit d'évacuation », qui a pour rôle d'acheminer le fluide réfrigérant dit « chaud » (ou « réchauffé »), c'est-à-dire qui a collecté des calories produites par les processeurs et autres composants électroniques (i.e. la chaleur émise), en dehors de la plaque froide 1, par exemple vers une unité de refroidissement du fluide réfrigérant disposée en dehors de la lame de calcul. Une telle unité de refroidissement peut être de type échangeur à plaques eau/eau. Dans cet échangeur circule, d'un côté, le fluide réfrigérant dit « réchauffé/chaud », et de l'autre le réseau d'eau du client qui récupère les calories du précédent réseau.

Selon l'invention, la plaque froide 1 est réalisée par assemblage mécanique d'une pluralité d'éléments.

Dans l'exemple illustré sur la figure 1, la plaque froide 1 comprend tout d'abord un bord proximal 10 longiligne qui a pour fonction de permettre l'entrée et la sortie du fluide réfrigérant de la plaque froide 1. En d'autres termes, le bord proximal 10 constitue le début du circuit de refroidissement et la fin du circuit d'évacuation.

A cette fin, le bord proximal 10 comprend à l'une de ses extrémités un connecteur d'entrée 110 de fluide réfrigérant et à son autre extrémité un connecteur de sortie 120 de fluide réfrigérant. Le connecteur d'entrée 110 et le connecteur de sortie 120 sont montés sur le bord proximal 10 à l'aide de vis 100.

Le connecteur d'entrée 110 et le connecteur de sortie 120 sont configurés chacun pour recevoir un tube, par exemple flexible, permettant de connecter la plaque froide 1 au module de refroidissement du fluide réfrigérant, notamment lorsque la plaque froide 1 est montée dans la lame de calcul.

Toujours dans l'exemple illustré sur la figure 1, le bord proximal 10 est monté sur une pièce centrale 20 sensiblement rectangulaire permettant d'acheminer le fluide vers les dissipateurs thermiques. Le bord proximal 10 et la pièce centrale 20 sont assemblés à l'aide de vis 100.

La plaque froide 1 comprend ensuite un bord distal 30 relié à la pièce centrale 20 par un premier organe de liaison 40 et par un deuxième organe de liaison 50.

Le bord distal 30 comporte une partie du circuit d'évacuation.

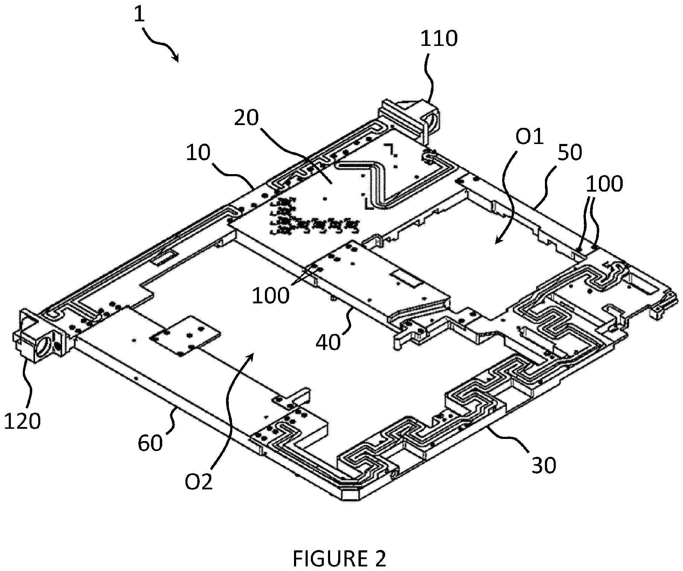

En référence à la figure 2, la pièce centrale 20, le bord distal 30, le premier organe de liaison 40 et le deuxième organe de liaison 50, une fois assemblé, délimitent une première ouverture O1 destinée à recevoir un dissipateur thermique (non représenté par souci de clarté) qui est configuré pour se connecter d'une part au circuit de refroidissement au niveau de la pièce centrale 20 pour recevoir le fluide réfrigérant froid et d'autre part au circuit d'évacuation du bord distal 30 pour évacuer le fluide réfrigérant réchauffé vers le connecteur de sortie 120.

Afin d'acheminer le fluide réfrigérant réchauffé du bord distal 30 au bord proximal 10, la plaque froide 1 comprend un organe de jonction fluidique 60 monté entre le bord proximal 10 et le bord distal 30. En d'autres termes, l'organe de jonction fluidique 60 fait partie du circuit d'évacuation et permet d'acheminer le fluide réfrigérant réchauffé du bord distal 30 au bord proximal 10 qui le conduit ensuite jusqu'au connecteur de sortie 120.

Toujours en référence à la figure 2, le bord proximal 10, la pièce centrale 20, le bord distal 30, le premier organe de liaison 40 et l'organe de jonction 60, une fois assemblé, délimitent une deuxième ouverture O2 destinée à recevoir deux paires de dissipateurs thermiques (non représentés par souci de clarté) qui sont chacun configurés pour se connecter d'une part au circuit de refroidissement au niveau de la pièce centrale 20 pour recevoir le fluide réfrigérant froid et d'autre part au circuit d'évacuation du bord distal 30 et à l'organe de jonction 60 pour évacuer le fluide réfrigérant réchauffé vers le connecteur de sortie 120.

Etant donné que le circuit de refroidissement et le circuit d'évacuation sont constitués par des éléments distincts, des organes d'étanchéité sont utilisés au niveau des liaisons fluidiques entre les différents éléments.

Dans la forme de réalisation de la figure 1, les organes d'étanchéité se présentent sous la forme de joints toriques 200 placés à l'interface de chaque liaison fluidique entre deux éléments. Sur la figure 1, seuls les joints toriques 200 placés au niveau des liaisons fluidique entre le bord proximal 10 et la pièce centrale 20 et le joint torique placé entre le connecteur d'entrée 110 et le bord proximal 10 ont été représentés par souci de clarté mais il va de soi que l'ensemble des liaisons fluidiques entre les éléments de la plaque froide 1 sont munis de tels joints toriques 200 pour assurer l'étanchéité du circuit de circulation de fluide réfrigérant dans ladite plaque froide 1.

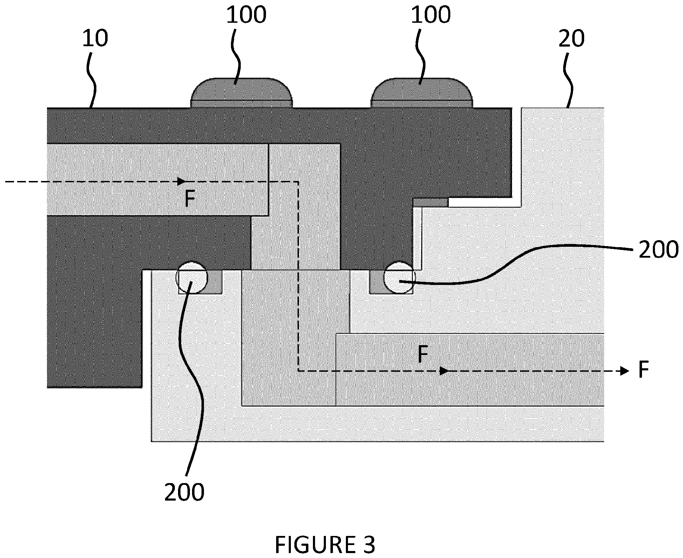

En référence à la figure 3, sur laquelle on a représenté une interface de liaison fluidique entre le bord proximal 10 et la pièce centrale 20, le joint torique 200 est placé dans une gorge formée, dans cet exemple non limitatif, dans la pièce centrale 20 de sorte à être en compression contrôlée autour de la connexion fluidique entre le bord proximal 10 et la pièce centrale 20. Ainsi, le flux F de fluide réfrigérant peut cheminer du bord proximal 10 à la pièce centrale 20 sans perte. Comme indiqué ci-avant, des organes d'étanchéité, notamment de type joint torique 200, peuvent être utilisés où cela est nécessaire à l'interface des liaisons fluidiques dans le circuit de circulation de fluide réfrigérant (circuit de refroidissement et circuit d'évacuation).

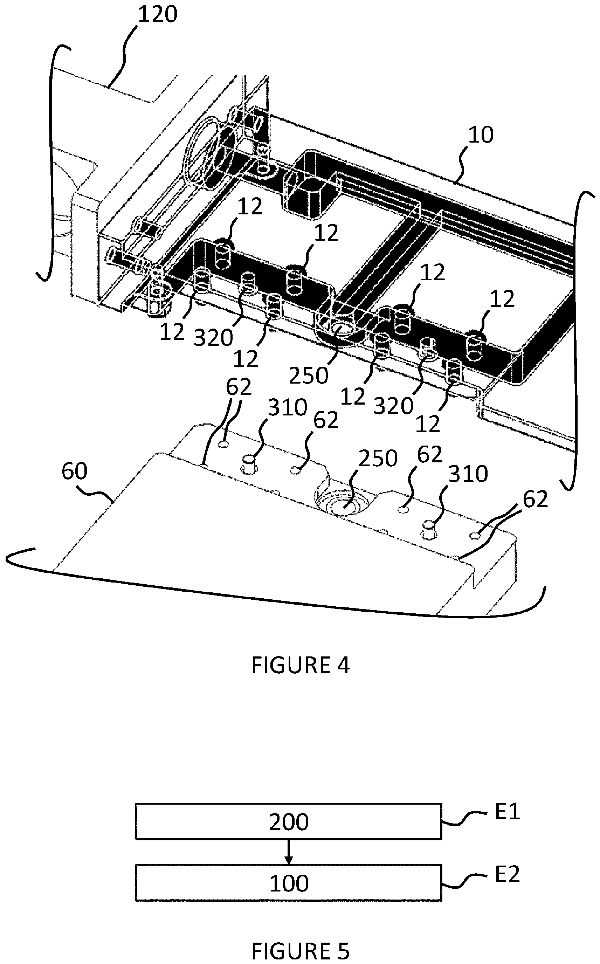

En référence à la figure 4, sur laquelle est représentée la jonction entre le bord proximal 10 et l'organe de jonction 60, des organes de positionnement sont utilisés afin de faciliter l'assemblage des éléments et garantir le bon alignement des orifices 250 du circuit d'évacuation.

Ces organes de positionnement comprennent notamment des pions d'indexage 310 adaptés pour se loger dans des cavités de blocage 320 complémentaires, de préférence avec des tolérances serrées (i.e. inférieures ou de l'ordre du millimètre). Dans l'exemple de la figure 4, l'organe de jonction 60 comprend deux pions d'indexage 310, disposés symétriquement de part et d'autre de la liaison fluidique du circuit d'évacuation et le bord proximal 10 comprend deux cavités de blocage 320.

La figure 4 illustre également les orifices de réceptions des vis 100 à la fois au niveau du bord proximal 10 (orifices 12) que de l'organe de jonction (orifices 62).

### Assemblage de la plaque froide

Tout d'abord, dans une étape E1, des joints toriques 200 sont placés autour des jonctions fluidiques du circuit de circulation de fluide réfrigérant de la plaque froide 1 à l'interface des éléments de la plaque froide 1 concernés par ledit circuit de circulation.

Les éléments sont assemblés deux à deux par serrage des vis 100 dans les orifices 12, 62 correspondants dans une étape E2. Lors du serrage des vis 100, les joints toriques 200 sont comprimés en compression contrôlée jusqu'en butée des éléments de la plaque froide 1 de sorte à garantir l'étanchéité des liaisons fluidiques.

La plaque froide 1 selon l'invention permet, grâce à un assemblage d'éléments, une adaptabilité à tout type et forme de dissipateur thermique tout en économisant le volume de matière des ouvertures qui était autrement usiné et donc supprimé. Les organes d'étanchéité permettent de garantir l'étanchéité du circuit de circulation de fluide réfrigérant et ainsi l'efficacité de la plaque froide 1.

## Revendications

1. Plaque froide (1) pour lame de calcul de supercalculateur, ladite plaque froide (1) délimitant au moins une ouverture (O1, O2) configurée pour recevoir au moins un dissipateur thermique destiné à refroidir au moins un composant électronique, ladite plaque froide (1) comprenant un circuit de refroidissement, comportant des canaux à l'intérieur desquels est destiné à circuler un fluide caloporteur dit « froid » pour alimenter ledit au moins un dissipateur thermique, et un circuit d'évacuation, comportant des canaux à l'intérieur desquels est destiné à circuler un fluide caloporteur dit « chaud » après réchauffement à travers l'au moins un dissipateur thermique, ladite plaque froide (1) étant **caractérisée en ce qu'**elle consiste en un assemblage de plusieurs éléments distincts, dans lequel chaque paire d'éléments (10, 20, 30, 40, 50, 60) adjacents reliés fluidiquement au niveau d'une portion du circuit de refroidissement ou du circuit d'évacuation comporte à l'interface de ladite liaison un organe d'étanchéité (200).

2. Plaque froide (1) selon la revendication 1, dans laquelle l'organe d'étanchéité est de type joint torique (200).

3. Plaque froide (1) selon l'une quelconque des revendications précédentes, dans laquelle les éléments (10, 20, 30, 40, 50, 60) de la plaque froide (1) sont fixés entre eux deux à deux par des organes de fixation (100).

4. Plaque froide (1) selon la revendication précédente, dans laquelle les organes de fixation sont de type vis de fixation (100).

5. Plaque froide (1) selon l'une quelconque des revendications précédentes, dans laquelle au moins une paire d'éléments (10, 20, 30, 40, 50, 60) de la plaque froide (1) comporte des organes de positionnement (310, 320).

6. Plaque froide (1) selon la revendication précédente, dans laquelle les organes de positionnement comprennent au moins un pion d'indexage (310) s'insérant dans une forme complémentaire (320).

7. Plaque froide (1) selon l'une quelconque des revendications précédentes, dans laquelle les éléments (10, 20, 30, 40, 50, 60) sont réalisés en métal, de préférence en aluminium.

8. Procédé d'assemblage d'une plaque froide (1) selon l'une quelconque des revendications précédentes, ledit procédé comprenant une étape (E1) de positionnement des éléments (10, 20, 30, 40, 50, 60) entre eux et une étape (E2) de fixation des éléments entre eux de sorte à former le circuit de refroidissement et le circuit d'évacuation, le positionnement (E1) des éléments (10, 20, 30, 40, 50, 60) entre eux comprenant le placement d'un organe d'étanchéité (200) à chaque interface de liaison fluidique d'une portion du circuit de refroidissement ou du circuit d'évacuation d'éléments (10, 20, 30, 40, 50, 60) adjacents.

9. Procédé selon la revendication précédente, dans lequel la fixation se fait par emboitement ou par vissage.

10. Procédé d'assemblage d'une plaque froide selon l'une quelconque des revendications 8 ou 9, le positionnement (E1) des éléments (10, 20, 30, 40, 50, 60) entre eux comprenant le guidage d'au moins une partie des éléments (10, 20, 30, 40, 50, 60) par des organes de positionnement (310, 320).
